(19) **Europäisches Patentamt**
**European Patent Office**
**Office européen des brevets**

(11) **EP 4 035 273 B1**

(12) **EUROPEAN PATENT SPECIFICATION**

(45) Date of publication and mention
of the grant of the patent:
**17.01.2024 Bulletin 2024/03**

(21) Application number: **19790200.0**

(22) Date of filing: **18.10.2019**

(51) International Patent Classification (IPC):
$H03M\ 13/13$ (2006.01)  $H03M\ 13/21$ (2006.01)
$H03M\ 13/00$ (2006.01)  $G06N\ 3/08$ (2023.01)
$G06N\ 3/02$ (2006.01)  $G06N\ 3/048$ (2023.01)
$G06N\ 3/063$ (2023.01)

(52) Cooperative Patent Classification (CPC):
**H03M 13/6597; G06N 3/048; G06N 3/063;
G06N 3/08; H03M 13/136; H03M 13/21;
H03M 13/6577**

(86) International application number:
**PCT/EP2019/078362**

(87) International publication number:
**WO 2021/073752 (22.04.2021 Gazette 2021/16)**

(54) **DESIGN AND TRAINING OF BINARY NEURONS AND BINARY NEURAL NETWORKS WITH ERROR CORRECTING CODES**

ENTWURF UND TRAINING VON BINÄREN NEURONEN UND BINÄREN NEURONALEN NETZEN MIT FEHLERKORREKTURCODES

CONCEPTION ET FORMATION DE NEURONES BINAIRES ET DE RÉSEAUX NEURONAUX BINAIRES AVEC DES CODES DE CORRECTION D'ERREUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.08.2022 Bulletin 2022/31**

(60) Divisional application:
**23206103.6**

(73) Proprietor: **Huawei Technologies Co., Ltd.
Longgang District,
Shenzhen, Guangdong
518129 (CN)**

(72) Inventors:
• **PASCHOS, Georgios**
**80992 Munich (DE)**
• **TSILIMANTOS, Dimitrios**
**80992 Munich (DE)**
• **DESTOUNIS, Apostolos**
**80992 Munich (DE)**
• **VASSILARAS, Spyridon**
**80992 Munich (DE)**

• **COSTANTINI, Marina**
**80992 Munich (DE)**
• **LIAKOPOULOS, Nikolaos**
**80992 Munich (DE)**
• **NGUYEN, Van Minh**
**80992 Munich (DE)**
• **DEBBAH, Merouane**
**80992 Munich (DE)**
• **BELFIORE, Jean-Claude**
**80992 Munich (DE)**

(74) Representative: **Epping - Hermann - Fischer
Patentanwaltsgesellschaft mbH
Schloßschmidstraße 5
80639 München (DE)**

(56) References cited:
**EP-A1- 0 548 127**

**(Cont. next page)**

- **Mohammad Rastegari ET AL: "XNOR-Net: ImageNet Classification Using Binary Convolutional Neural Networks" In: "12th European Conference on Computer Vision, ECCV 2012", 2 August 2016 (2016-08-02), Springer Berlin Heidelberg, Berlin, Heidelberg 031559, XP055678493, ISSN: 0302-9743 ISBN: 978-3-642-36741-0 vol. 9908, pages 525-542, DOI: 10.1007/978-3-319-46493-0_32, cited in the application the whole document**
- **BRUCK J ET AL: "NEURAL NETWORKS, ERROR-CORRECTING CODES, AND POLYNOMIALS OVER THE BINARY N-CUBE", IEEE TRANSACTIONS ON INFORMATION THEORY, IEEE PRESS, USA, vol. 35, no. 5, 1 September 1989 (1989-09-01), pages 976-987, XP000100931, ISSN: 0018-9448, DOI: 10.1109/18.42215**

**Description**

**FIELD OF THE INVENTION**

This disclosure relates to deep neural networks, particularly to the design and training of binary neurons and binary neural networks.

**BACKGROUND**

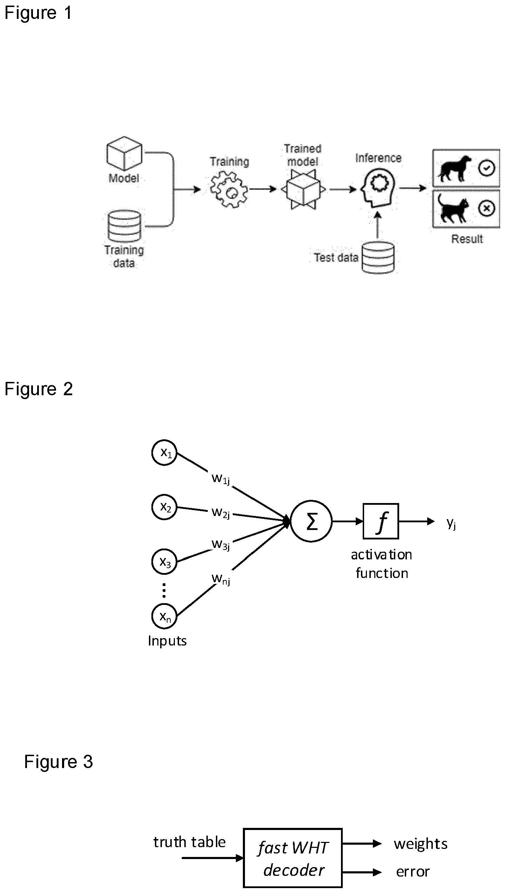

Deep Neural Networks (DNNs) are computing systems inspired by the biological neural networks that constitute biological brains. DNNs "learn" to perform tasks by considering examples, generally without being programmed with any task-specific rules. For example, in image recognition, they might learn to identify images that contain cars by analyzing example images that have been manually labeled as "car" or "no car" and using the results to identify cars in other images. They do this without any prior knowledge about cars. Instead, they automatically generate identifying features from the learning material that they process. Figure 1 shows a general scheme of this process.

A DNN is based on a collection of connected units or nodes called artificial neurons, which loosely model the neurons in a biological brain. Each connection, like the synapses in a biological brain, can transmit a signal from one artificial neuron to another. An artificial neuron that receives a signal can process it and then activate additional artificial neurons connected to it. Typically, artificial neurons are aggregated into layers, where different layers may perform different kinds of transformations on their inputs.

In common DNN implementations, the signal at a connection between artificial neurons is a real number, and the output of each artificial neuron is computed by some non-linear function of the sum of its inputs. The connections between artificial neurons are called 'edges'. The edges typically have a weight that adjusts as learning proceeds. The weight increases or decreases the strength of the signal at a connection. Artificial neurons may have a threshold such that the signal is only sent if the aggregate signal crosses that threshold.

A single artificial neuron is shown in Figure 2. The inputs ($x_1$, $x_2$, ... , $x_n$) can either be the input signal, or the outputs of the previous neuron layer. Each input $x_i$ is first multiplied with a weight $w_{ij}$, where j indicates the neuron index, and then the products are summed. In some cases, a bias $w_{0j}$ is added to this sum. Then the net input is passed through a non-linear activation function, and finally a single output $y_j$ is produced.

DNNs are ubiquitous today, permeating every aspect of modern communication networks. Therefore, it comes as no surprise that DNNs are expected to play a very important role in devices in future networks, such as smartphones, sensors and wearables. Especially for smartphones, there is already a big market for DNNs, with various diverse applications, including image recognition, portrait mode photography, text prediction, user profiling, de-noising and camera enhancement.

However, their implementation on such resource constrained devices is limited by the high resource consumption (memory and energy). In the standard implementation of DNNs, all inputs, outputs, weights, biases, and activation functions are considered to be real numbers, and are typically represented in computers with floating point arithmetic, meaning that each number is approximated using a 64-bit sequence. In deep learning applications, there may be DNNs with thousands of neurons, where each neuron may have numerous inputs, resulting in millions of such floating point numbers.

For this reason, recent research has focused on compressing DNNs using a smaller-digit arithmetic, i.e., binary, ternary, or 8-bit. Such an approach essentially represents each number (input, output, weight) with less bits than a float would use. However, decreasing the representation bits has a detrimental effect on accuracy. For the same number of neurons, each neuron is now less potent in describing relations, and therefore an error may be introduced. On the other hand, it is possible to increase the number of neurons and theoretically achieve the same accuracy as before. For example, in the worst-case, 64 binary neurons can simulate a floating point neuron. However, the hope in recent research is that this can be improved if binary neural networks can be properly designed.

Prior work has identified that reducing the arithmetic precision can greatly enhance the performance of the DNNs without necessarily sacrificing accuracy. However, training of low-precision DNNs becomes the new bottleneck and is one of the key problems in the domain of machine learning today.

I. Hubara, M. Courbariaux, D. Soudry, R. El-Yaniv, and Y. Bengio, "Quantized Neural Networks: Training Neural Networks with Low Precision Weights and Activations", Journal of Machine Learning Research, 18(187), 1-30, 2017, and M. Rastegari, V. Ordonez, J. Redmon, and A. Farhadi, "XNOR-Net: ImageNet Classification Using Binary Convolutional Neural Networks", European Conference on Computer Vision, 525-542, 2016, provides designs of binary neural networks (BNNs) that reduce memory usage by 32 times, achieve a tenfold decrease in energy consumption, and reduce significantly inference time compared to DNNs with continuous weights. These results justify the quest for developing low-precision NN architectures and training algorithms which achieve accuracies close to those achieved by their continuous-weights counterparts.

However, training a neural network with low-precision weights (even a single-layer one) is known to be an NP-hard optimization problem. In particular, due to weight discretization, the backpropagation algorithm used in continuous DNNs, which is based on computing the gradient of the loss function, cannot be used effectively. The problem of unstable gradients appears as soon as the number of bits for representing numbers is less than 8.

Thus, most prior work in efficient training of low-precision neural networks is based on the use of gradient approximations, which require storing a floating point weight along with the low precision weight and performing some form of backpropagation with floating point arithmetic (thus relinquishing some of the discretization advantage).

In order to address this issue, these works keep a full precision value for each weight and then (i) binarize this value and (ii) update the full precision value by a straight-through estimator for the gradient evaluated on the binarized value.

The algorithm described in C. Leng, Z. Dou, H. Li, S. Zhu, R. Jin, "Extremely Low Bit Neural Network: Squeeze the Last Bit Out with ADMM", The Thirty-Second AAAI Conference on Artificial Intelligence (AAAI-18), 3466-3473, also stores two versions of the weights: a low precision and a high precision one, and seeks to optimize a function that severely penalizes the distance between the two, thus forcing the high precision weights to take values very close to the low precision ones.

An alternative approach based on Bayesian modelling is described in D. Soudry, I Hubara, R. Meir, "Expectation Backpropagation: parameter-free training of multilayer neural networks with continuous or discrete weights", 27th International Conference on Neural Information Processing Systems (NIPS), 2014, wherein each weight is characterized by a probability distribution, which is updated at training. The BNN is then specified by sampling weights from given distributions. Procedures along these lines can produce BNNs during training, but they still need to operate on full precision real numbers, thus they are unsuitable for use on battery-powered devices.

Another approach to train BNNs are algorithms inspired from statistical physics. The approaches in C. Baldassi and A. Braunstein, "A Max-Sum algorithm for training discrete neural networks", Journal of Statistical Mechanics: Theory and Experiments, Aug. 2015, and C. Baldassi, "Generalization Learning in a Perceptron with Binary Synapses", Journal of Statistical Physics, vol. 136, no. 5, 902-916, Sept. 2009, provide training algorithms that keep and update an integer "hidden weight" for every binary weight. It has been illustrated that these integer hidden weights can also have bounded magnitude. This feature greatly reduces the complexity of operations, making these algorithms more attractive for on-device use. However, the algorithms are designed for specific types of networks and cannot be applied in a straightforward manner to more general and deep architectures.

The work in C. Baldassi, A. Ingrosso, C. Lucibello, L. Saglietti, R. Zecchina, "Subdominant Dense Clusters Allow for Simple Learning and High Computational Performance in Neural Networks with Discrete Synapses", Physical Review Letters, vol. 115, no. 12, Sept. 2015, provides an efficient algorithm based on belief propagation, but as in the previous works, this applies to a single perceptron and it is unclear how to use it for networks with multiple layers.

An alternative approach to overcome the lack of gradient information is to address training as a combinatorial optimization problem and apply a known solution method for this kind of problems. For example, Evolutionary Algorithms (EA) have been proposed as a training method for NNs in general, as described in G. Morse and K. O. Stanley, "Simple Evolutionary Optimization Can Rival Stochastic Gradient Descent in Neural Networks", The Genetic and Evolutionary Computation Conference (GECCO), July 2016, and low-precision DNNs in particular, as described in R. Ito and T. Saito, "Dynamic binary neural networks and evolutionary learning", The International Joint Conference on Neural Networks (IJCNN), July 2010.

However, EAs suffer from performance and scalability issues. Firstly, although only low-precision weights are considered, the number of weights stored in memory is multiplied by the population size, and therefore, even for binary weights and a modest population size of 100, the memory footprint is larger than storing decimal weights with 16, 32 or 64 bits floating point representation. Secondly, a single forward pass during training has to be performed for all members of the population. Even though this can be done in parallel, having as many parallel processors as the population size is prohibitive for training on a mobile device. Finally, it is well known that the population size should increase with the number of weights (dimension of the optimization parameter space), making scaling for big neural networks problematic.

Thus, there exists no known scalable and efficient algorithm in the literature to train a low-precision DNN purely on a smartphone. Consequently, the current state of the art approach is to perform the computationally demanding training phase by using floating point arithmetic on the cloud, where the resource limitations are relaxed. Then, a low-precision version of the DNN is provided on the smartphone to perform the less demanding inference (feedforward) phase on unseen data. However, this is a procedure that can produce only a fixed pre-trained low-precision DNN, which is a major limitation of the prior art.

Low-precision neural networks can be implemented in software or hardware. Binary neural networks in particular, are known to have very efficient implementations based on bitwise operations (in software) or digital logic circuits such as NOR or XNOR (in hardware).

WO 1992012497 A1 and US 10089577 B2 describe the use of specific hardware designs for a neuron for implementing BNNs. WO 1992012497 A1 concerns neural networks used as associative memories and implements each neuron as a 'NOR' logic function so that its output is active only if all its inputs are inactive. In US 10089577 B2, XNOR is performed between the input signals of each neuron and the corresponding weights and then the number of resulting 1s is compared against a threshold to determine the output (activation function). Moreover, no training method is proposed.

WO 1992/04687 A1, which corresponds to EP 0 548 127 A0, describes a process by means of which ADALINE-type neural networks whose inputs are Boolean variables can be realized using Boolean functions. For training the network as simulated annealing process is described.

It is desirable to design binary neurons and neural networks in order to completely binarize DNNs, enabling artificial intelligence (AI) in smartphones with compact AI chipsets, reduced energy consumption and training acceleration.

## SUMMARY OF THE INVENTION

According to a first aspect, there is provided a data processing system having a neural network architecture for receiving a binary network input and in dependence on the binary network input propagating signals via a plurality of binary processing nodes, in accordance with respective binary weights, to form a network output, the data processing system being configured to train each node of the plurality of binary processing nodes by implementing an error correcting function that expresses error correction code to identify a set of binary weights which minimize, for a given input to the respective node, any error between an output of the respective node when formed in accordance with current binary weights of the respective node and a preferred output from the node and to update the binary weights of the respective node to be the identified binary weights. This training may be performed in the binary field without storing and/or using any higher arithmetic precision weights or other components.

The approach may therefore train a "binary field" neuron and/or neural network without storing and/or using any higher arithmetic precision weights or other components. The approach can be implemented on artificial intelligence chipsets in a simple, standalone, and modular manner, as required for mass production. This solution may present minor losses in accuracy for dramatic benefits in simplicity, space, thermal properties, memory requirements, and energy consumption and can be used for federated learning, user profiling, privacy, security and optimal control. The approach takes one step closer to a precise form of Boolean functions to be used, inspired by properties from the channel coding theory.

The respective node may be configured to receive a node input dependent on the binary network input and to form a node output that is binary and is functionally equal to the sum in the binary field of (i) a first weight, (ii) the sum in the binary field of the products of (a) each of the bits of the node input, (b) a respective one of a set of second weights and (iii) a value indicative of whether all the bits of the node input are non-zero. This may provide an efficient way of implementing a flexible computation node.

The said one of the nodes may be configured to form a node output that is functionally equal to a coset of a first order Reed-Muller code, wherein the coset kernel takes as input the bits of the node input. This may permit the node to efficiently process binary data.

The respective node may be implemented as a set of logic circuits configured so that:

(i) each bit of the node input is subject to a logical AND function with a respective weight to form a respective first intermediate value;
(ii) all bits of the node input are together subject to a logical AND function to form a second intermediate value; and
(iii) a further weight, the first intermediate values and the second intermediate value are together subject to a logical XOR function to form the node output. This may facilitate efficient processing of binary data.

The network may comprise a plurality of blocks, each block comprising at least three logic circuits as set out as described above, the logic circuits being configured so that first and second ones of the logic circuits receive block inputs dependent on the network input and form first and second intermediate block values, and the third one of the logic circuits receives as input the intermediate block values and forms an output from the block. A block of this form can efficiently form a component of more complex computational structures. The interconnections between the blocks may depend on the desired boolean function to be implemented.

The first logic circuit may be configured to apply weights as the weights of a binary perceptron and the second logic circuit may have fixed weights. The fixed weights may be zero. This can permit the first logic circuit to efficiently process input data.

The third logic circuit may receive as input (i) a single instance of the first intermediate block value and (ii) multiple instances of the second intermediate block value. This can allow the third logic circuit to process data in an efficient manner.

The third logic circuit may be configured to apply fixed weights to all the inputs of the third logic circuit with the exception of one instance of the second intermediate block value. This can allow the third logic circuit to process data in an efficient manner.

The third logic circuit may be configured to apply a weight equal to the sum in the binary field of the weights of the first logical circuit to the said instance of the second intermediate block value. This can allow the third logic circuit to process data in an efficient manner.

The data processing system may comprise a plurality of sub-systems, the sub-systems each comprising the data processing system as described above, wherein the data processing system is configured to provide the output of at least one of the sub-systems as an input to at least one of the other sub-systems. The connections between the plurality of sub-systems may be configured in dependence on the desired Boolean function to be implemented.

The data processing system may be configured to adapt the weights for the respective node in dependence on a set of expected node outputs expected for a set of node inputs by the steps of: forming a set of values representing, for each node input, whether the expected node output is (i) zero, (ii) one or (iii) indifferent; and identifying an $i^{th}$ row of a Hadamard matrix that best matches the set of values; and adapting the weights for the node in dependence on the identification. The weights for the node may be adapted using any procedure for decoding an error-correcting code. This can allow the data processing system to efficiently learn in response to input data.

The data processing system may be configured to form a set of values representing, for each node input, whether the respective node output obtained after the weights have been adapted matches the expected node output. This may be performed using any procedure for decoding error-correcting codes. This can provide feedback to the learning process.

The data processing system may be configured to adapt the weights for the respective node in dependence on a set of expected node outputs expected for a set of node inputs by operating a fast Walsh-Hadamard function taking as input the set of expected node outputs. This can provide feedback to the learning process.

According to a second aspect, there is provided a communication terminal comprising a sensor and a data processing system as described above, the communication terminal being configured to sense data by means of the sensor to form the network input.

The sensor may be a camera.

The terminal may be configured to perform error correction on data received over a communication link using the said data processing system.

According to a third aspect, there is provided a computer program for implementation in a system having a neural network architecture for receiving a binary network input and in dependence on the binary network input propagating signals via a plurality of binary processing nodes, in accordance with respective binary weights, to form a network output, which, when executed by a computer, causes the computer to perform a method comprising training each node of the plurality of binary processing nodes by implementing an error correcting function that expresses error correction code to identify a set of binary weights which minimize, for a given input to the respective node, any error between an output of the respective node when formed in accordance with current binary weights of the respective node and a preferred output from the respective node and to update the weights of the respective node to be the identified weights. The computer program may be provided on a non-transitory computer readable storage medium.

## BRIEF DESCRIPTION OF THE FIGURES

The present disclosure will now be described by way of example with reference to the accompanying drawings. In the drawings:

Figure 1 shows a diagram of the stages of neural network training.

Figure 2 illustrates an artificial neuron.

Figure 3 illustrates a Fast Walsh Hadamard transform flow diagram.

Figure 4 shows an example of a circuit of three inputs implementing the activation function of the binary field neuron.

Figure 5 shows a symbol to indicate binary field neuron of M inputs.

Figure 6(a) shows a circuit of the binary field perceptron.

Figure 6(b) shows the symbol of the circuit in Figure 6(a).

Figure 7(a) shows a circuit that can implement a Boolean monomial, a Boolean term or a weighted OR gate.

Figure 7(b) shows a symbol to indicate a Boolean monomial.

Figure 7(c) shows a symbol to indicate a Boolean term.

Figure 8 shows a circuit that can implement the algebraic normal form (ANF of any Boolean function. From layer 4 to the output neuron (n layers in total) the number of neurons in each layer is indicated at the top.

Figure 9(a) shows a symbol used to indicate an OR gate where the inputs over which to perform the OR operation can be selected ("weighted OR").

Figure 9(b) shows a symbol to indicate an OR gate where the operation is applied taking into account all inputs (equivalent to weighted OR with $\alpha_i = 1$, $i = 1, \ldots, M$).

Figure 10 shows a circuit that can implement the DNF of any Boolean function. From layer 4 to the output neuron (n layers of OR gates in total), the number of OR gates in each layer is indicated at the top.

Figure 11 shows an example of a data processing system.

## DETAILED DESCRIPTION OF THE INVENTION

The present disclosure proposes a purely binary neural network, by introducing an architecture that is based on binary field arithmetic and transforms the training problem into a communication channel decoding problem.

An artificial neuron has a number of inputs and weights and returns one output. It is commonly seen as a function which is parameterized by the weights and takes a neuron's inputs as variables to return the output. In the context of BNNs, of particular concern is the development of binary neurons whose inputs, weights, and output are all binary numbers. Interestingly, such structure of binary neuron fits with Boolean functions.

Let m be the number of variables and $x = (x_1, x_2, \ldots, x_m) \in F_2^m$ be a binary m-tuple. A Boolean function is any function $f(x) = f(x_1, x_2, \ldots, x_m)$ that takes values in F$_2$. It can be specified by a truth table which defines the value of $f$ at all of the $2^m$ input combinations. Table 1 gives an example of the truth table of a binary sum function (XOR function).

Table 1: Example of a truth table of a Boolean function (XOR).

| $x_1$ | $x_2$ | $f = x_1 + x_2$ |
|-------|-------|-----------------|
| 0 | 0 | 0 |
| 0 | 1 | 1 |
| 1 | 0 | 1 |
| 1 | 1 | 0 |

The Boolean function $f$ is specified by a binary vector of length $2^m$, thus there are in total $2^{2^m}$ functions of m variables. Since $x_i^2 = x_i$ for $x_i \in$ F$_2$, any Boolean function is a binary combination of the basis functions:

$$\{1, \quad x_i, \quad x_i x_{j, j \neq i}, \quad x_i x_{j, j \neq i} x_{k, k \neq i, j}, \quad \ldots, \quad x_1 x_2 \ldots x_m\} \qquad (1)$$

Boolean functions provide a natural way for modeling binary neurons, in particular from the feedforward perspective where the neuron acts like a function to give an output from the provided inputs. From this perspective, training a binary neuron is equivalent to fitting a Boolean function, i.e. finding a function that best approximates an output target when given a specific input. This formulation allows to apply well-known tools to solve the function fitting and thus also the neuron training, as explained next.

Boolean functions that express error correcting codes appear as a concrete and suitable candidate for binary neuron implementation due to their key advantage: as a code they have a built-in structure which translates the function fitting into a decoding task in a straightforward manner.

The present disclosure proposes binary field neurons that can be conveniently trained using channel coding theory and a number of circuits built using exclusively this type of neurons that have the capability of solving any learning problem with discrete inputs and discrete outputs.

The latter is possible thanks to (i) the capability of the proposed neuron activation function of generating non-linear functions of its inputs, and (ii) the fact that with a sufficient number of such neurons connected in a convenient manner any Boolean function can be implemented by the network. This implies that potentially any combination of inputs and labels can be learned by the system.

Furthermore, for fixed inputs, the function implemented by the neuron is linear in the neuron parameters, which allows to see the weight vector of each neuron as a specific error correcting code and thus to formulate the neuron training problem as a channel decoding problem.

Details of an exemplary binary field neuron and a number of circuits built with it that have the capability to solve any binary classification problem with binary inputs will now be described. Since any M-label classification problem can be formulated as M one-against-all binary classifications, the circuits presented here can be extended to build multiple-label classifiers with binary inputs.

In this example, the weight vector of each binary field neuron is a Reed-Muller code, which is an error-correcting code that can be simply defined in terms of Boolean functions. For m > 0 and $0 \leq r \leq m$, the r-th order Reed-Muller code, denoted $R(r,m)$, is the set of all vectors $\mathbf{f} \in F_2^n$ with n = $2^m$ obtained from Boolean function $f(x_1, x_2, \ldots, x_m)$ which is a Boolean polynomial of degree at most r.

The r-th order Reed-Muller code consists of all linear combinations of the column vectors corresponding to basis functions of at most degree r in Equation (1). There are $d = \sum_{i=0}^{r} \binom{m}{r}$ such basis vectors, which are linear independent. Thus, the code has dimension d and corresponds to a Boolean function with a truth table that consists of $2^d$ columns of length $2^m$.

The r-th order Reed-Muller code has minimum distance $2^{m-r}$. Higher code order increases the codebook size and the approximation accuracy, but reduces the minimum distance and makes the neuron less robust to miss-fitting data, which is in turn an important requirement.

A particular and interesting case is the 1st-order Reed-Muller code $R(1,m)$, which has the greatest minimum distance between Reed-Muller codes. It consists of $2^{m+1}$ linear Boolean functions given by:

$$f(x) = w_0 + \sum_{i=1}^{m} x_i w_i, \qquad (2)$$

where $x = (x_1, x_2, \ldots, x_m) \in F_2^m$ are the input variables and $w = (w_0, w_1, w_2, \ldots, w_m) \in F_2^{m+1}$ are the parameters specifying $f$. The 1st-order Reed-Muller code not only has the greatest minimum distance, but it is also computationally efficient thanks to its Hadamard-structure codebook that allows to perform computationally efficient decoding. It is however worth noting that the 1st-order Reed-Muller code is purely linear, see Equation (2), whereas, conceptually, artificial neurons are required to be able to express both linear and non-linear functions. Fortunately, the advantages of the 1st-order Reed-Muller code may be retained and at the same time satisfy the non-linearity expressibility requirement. That is done by using cosets of the 1st-order Reed-Muller code $CR(1,m)$ which are defined by:

$$f(x) = w_0 + \sum_{i=1}^{m} x_i w_i + \prod_{i=1}^{m} x_i, \qquad (3)$$

where the product on the right-hand side is the cosets kernel which provides the neuron with the capability of expressing the non-linear part. It is clear that the kernel is equal to 1 if $x_i$ = 1, $\forall i$, and 0 otherwise. The truth table of $CR(1, m)$ is directly obtained from that of $R(1, m)$ by just taking the binary complement of the last row. As a result, the Hadamard-structure codebook can be easily leveraged as in $R(1, m)$ for efficient decoding of $CR(1, m)$.

In this line of thought, the process of training a neuron is equivalent to finding the best training variables w that correspond to the best realizable function, according to a given optimization criterion. This problem is similar to a decoding problem, where the optimization criterion can be, for example, the minimization of errors between the desired truth table and the realizable function and the maximization of accuracy for the input training data set.

An example of realizable functions for $CR(1,2)$ is shown in Table 2. This table shows the set of $2^{m+1}$ = 8 realizable functions that are decodable without errors. In general there are $2^{2m}$ = 16 possible functions, which means that any truth table function that does not belong in the set of Table 2 has one or more errors for a specific $x$.

Table 2: Example of realizable functions for $m = 2$ binary inputs

| Input | | Output $y = \sum_i w_i x_i + w_0 + \prod_i x$ | | | | | | | |
|---|---|---|---|---|---|---|---|---|---|
| $x = [x_1, x_2]$ | | $w = [0,0]$ $w_0 = 0$ | $w = [0,1]$ $w_0 = 0$ | $w = [1,0]$ $w_0 = 0$ | $w = [1,1]$ $w_0 = 0$ | $w = [0,0]$ $w_0 = 1$ | $w = [0,1]$ $w_0 = 1$ | $w = [1,0]$ $w_0 = 1$ | $w = [1,1]$ $w_0 = 1$ |
| 0 | 0 | 0 | 0 | 0 | 0 | 1 | 1 | 1 | 1 |
| 0 | 1 | 0 | 1 | 0 | 1 | 1 | 0 | 1 | 0 |
| 1 | 0 | 0 | 0 | 1 | 1 | 1 | 1 | 0 | 0 |
| 1 | 1 | 1 | 0 | 0 | 1 | 0 | 1 | 1 | 0 |

An example of a method to decode a neuron will now be described.

The Hadamard-structure codebook for $CR(1, m)$ code, whose Boolean function is described in Equation (3), can be leveraged in order to find the best training variables w given a target truth-table. This is achieved by using the Walsh-Hadamard transform.

A Walsh matrix is a specific square matrix of dimensions $2^n$ with $n = \{1,2, ... \}$. For each entry $h_{ik}$ of the matrix, $h_{ik} \in \{-1,1\}$ and all rows and columns are orthogonal, i.e. the dot product equals to zero. The naturally ordered Walsh matrix is called Hadamard matrix, which is given by the recursive formula:

$$H(2^n) = \begin{bmatrix} H(2^{n-1}) & H(2^{n-1}) \\ H(2^{n-1}) & -H(2^{n-1}) \end{bmatrix}, \quad \text{with } H(2) = \begin{bmatrix} 1 & 1 \\ 1 & -1 \end{bmatrix} \qquad (4)$$

The Hadamard matrix provides a way to find the training parameters w that have the smallest distance from the desired truth table. For this purpose, let us define by $y$ the target truth table. Next, from $y$ the modified version $\tilde{y}$ may be obtained by following the transformation:

$$\tilde{y}_i = \begin{cases} -1, & \text{if } y_i = 1 \\ 1, & \text{if } y_i = 0 \\ 0, & \text{if } y_i = -1. \end{cases} \qquad (5)$$

This modification is performed so that the realizable functions, as shown in Table 2, are expressed by the rows (or columns) of the Hadamard matrix. Note that the last case of $y_i = -1$ represents an erasure, i.e. an input vector x for which there is no target value. As a final step, in order to take into account the non-linear part of the neuron function, the sign of the last entry of $\tilde{y}$ is inverted. The best row $i^*$ of the Hadamard matrix is then found as $i^* = \text{argmax}|d|$, where $d = H\tilde{y}$ is a vector that shows how close is each row of $H$ from the target vector $\tilde{y}$. Then, the optimal bias $w_0$ of the neuron is 0 if $\max(d) > \max(-d)$ and 1 otherwise. Furthermore, the weights $(w_1, w_2, ... , w_m)$ of the neuron are simply given by the binary representation of the integer $i^*$.

The previous methodology has the disadvantage that it requires a lot of memory, since the full Hadamard matrix needs to be constructed and it is also computationally demanding. The fast Walsh-Hadamard transform addresses both drawbacks by avoiding the construction of the Hadamard matrix and by reducing the complexity to $O(m2^m)$.

In summary, as shown in Figure 3, the fast Walsh-Hadamard transform operates as a decoder that, given the target truth table, it provides the best training variables w and also indicates the bits where there is a decoding error, i.e. the realizable function differs from the target truth table.

An example of a circuit to implement a binary field neuron and perceptron will now be described.

The neuron activation function in Equation (3) can be implemented in hardware with AND and OR logical gates.

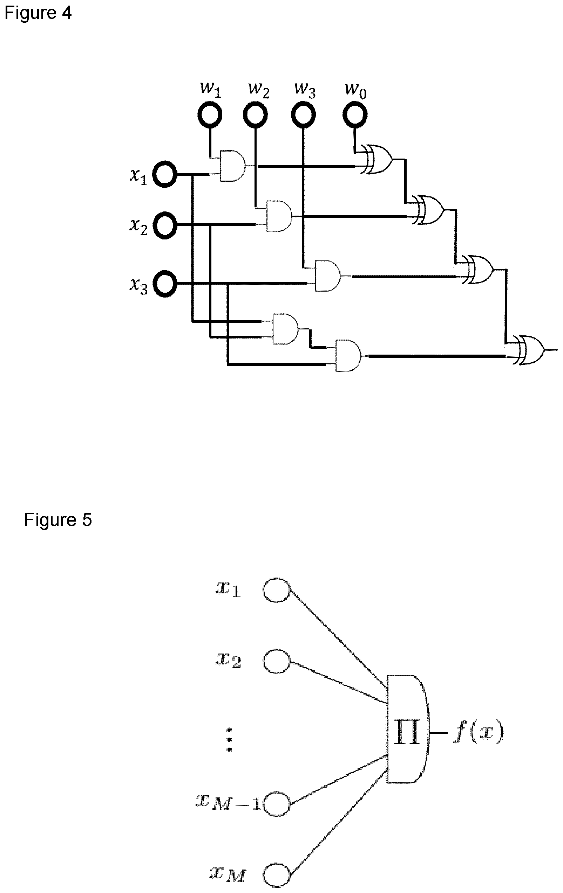

Figure 4 shows an example of a potential implementation for $M = 3$ inputs.

In the following, a neuron of $M$ inputs with activation function given by Equation (3) will be represented with the symbol shown in Figure 5. The specific value of the weights $w_1,... ,w_M$ may be indicated inside the symbol, and the bias $w_0$ on the top of the symbol. If only the $\Pi$ symbol appears, the weights are not fixed and would be found in the training. The symbols $1_M$ or $0_m$ inside the neuron indicate that the vector $(w_1, ... ,w_M)$ is the all-1 or the all-0 vector, respectively. In both cases the bias is $w_0 = 0$.

A small network can be built using exclusively neurons with activation function given by Equation (3) to have a circuit that implements the function given in Equation (2), i.e. a linear combination of the inputs plus a bias. This function is known as the binary perceptron.

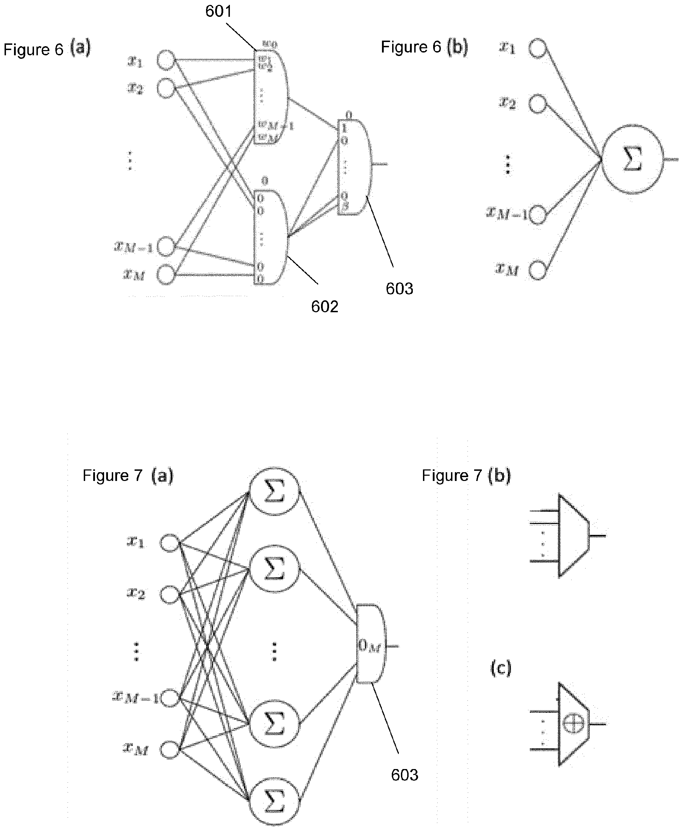

Figure 6(a) shows a circuit of the binary field perceptron that implements the function in Equation (2).

Figure 6(a) shows how to combine three binary field neurons 601, 602, 603 to get the binary perceptron. The network has two layers with two neurons 601, 602 in the first layer and one neuron 603 in the second. To achieve the function in Equation (2) at the output of the network, the weights of the first neuron 601 in the first layer take the perceptron parameter values and those of the second neuron 602 all take value 0. Note that this gives the product of all input variables $x_1,\dots,x_M$ at the output of the second neuron. The output of the first neuron 601 is connected to the first input of the second-layer neuron 603 and all the other inputs are connected to the output of the second neuron 602. The weight multiplying the output of the first neuron 601 is 1, and those multiplying the output of the second neuron 602 are all 0, except for one of them which takes value $\beta$. The value of $\beta$ is chosen so that at the output of the last-layer neuron 603 the product of all input variables is cancelled. To achieve this, $\beta$ takes the value

$$\beta = \sum_{m=0}^{M} w_m. \tag{6}$$

Figure 6(b) shows the symbol used to represent the network shown in Figure 6(a).

An example of a circuit to implement a Boolean monomial will now be described.

A Boolean monomial is a product of a subset of input variables $x_1,\dots,x_M$. An arbitrary monomial $\mu^k$ can be written as:

$$\mu^k = \prod_{m=1}^{M} x_m^{q_m^k}, \tag{7}$$

where $q_m^k = 1$ if variable $x_m$ appears in the monomial $\mu^k$ and 0 otherwise. Note that there are $K = 2^M$ such monomials given by all possible values of $q^k = (q_1^k,\dots,q_M^k)$.

Figure 7(a) shows a circuit composed of $M$ perceptrons and an output neuron that can implement any Boolean monomial. Since the perceptron can compute any linear function of its inputs, to get a monomial $\mu^k$ the parameters of each perceptron $i$, $i = 1, \dots, M$ are chosen to give $x_i$ if $q_i^k = 1$ and to give 1 if $q_i^k = 0$. The weights of the last neuron are set to $0_M$ so that this last neuron computes the product of the perceptron outputs only.

Figure 7(b) shows the symbol used in the remaining to represent the network shown in Figure 7(a) when the coefficients of the neurons are chosen so that at the output any monomial $\mu^k$ is generated.

An example of a circuit to implement a Boolean function in Polynomial Algebraic Normal Form (ANF) will now be described.

The Algebraic Normal Form (ANF) is a Boolean expression composed of XOR operations of Boolean monomials. The ANF of a Boolean function $f(x)$ can be written as:

$$f(x) = a_0 \oplus a_1 x_1 \oplus \dots \oplus a_M x_M \oplus a_{12} x_1 x_2 \oplus \dots \oplus a_{(M-1)M} x_{(M-1)} x_M \oplus \dots \oplus a_{1\dots M} x_1 \dots x_M \tag{8}$$

for some parameter values $a_0, \dots, a_{12\dots M}$ that depend on $f(x)$.

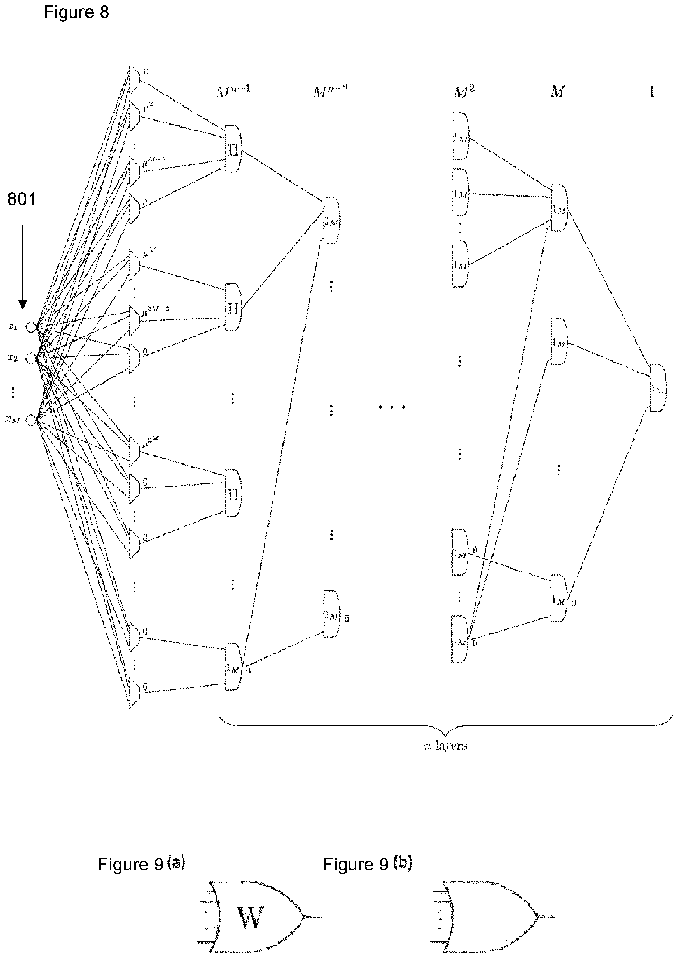

Figure 8 shows a network built with the binary field neuron that can compute an ANF of degree at most $M$. Since any Boolean function can be written in ANF (see O'Donnell R., "Analysis of boolean functions", Cambridge University Press, 2014, Jun 5), this network can implement any Boolean function of $M$ inputs, indicated at 801.

The first three layers of the network are arranged so that at the output of the third layer, all possible monomials $\mu^k$, $k = 1, \dots, 2^M$ are generated. There are $M^{(n-1)}$ additional monomials that generate 0 at their output and whose only function is to have for each neuron, from the fourth layer until the last one, an output in the previous layer that takes value 0 and that can thus be connected to the last input of every neuron. This allows the product term in Equation (3) to be cancelled and thus to have (from the fourth layer onwards) a network that only computes the XOR of all of its inputs to generate a unique value at the output. Thus, in order to add up all $2^M$ terms and ensure that at all layers there is at least one neuron in the previous layer whose output is 0, parameter n satisfies $(M - 1)M^{(n-1)} > 2^M$.

In this network, the first four layers have to generate the $2^M$ monomials, therefore the parameters of all neurons in these layers are fixed. Similarly, from the fifth layer onwards all inputs are just added up with XOR, thus the coefficients of all neurons in these layers take value 1 and the biases are all set to 0. The only free parameters are thus the weights of the neurons in the fourth layer, which should take value 1 if the monomial at their input $\mu^k$ appears in $f(x)$, and 0 otherwise.

An example of a circuit to implement a Boolean term will now be described.

A literal is a Boolean variable either negated ($\overline{x_i}$) or non-negated ($x_i$), and a Boolean term is a product of literals. In particular, a term where all M variables appear is called a full term and it can be expressed as:

$$\gamma^k = \prod_{m=1}^{M} [x_m^{(q_m^k - 1)} \oplus (\overline{x_m})^{q_m^k}], \qquad (9)$$

where, $q_m^k = 1$ if $x_m$ appears non-negated in term $\gamma^k$, and 0 otherwise. Note that there are $K = 2^M$ such terms given by all possible values of $q^k = (q_1^k, \dots, q_M^k)$.

The circuit with $M$ perceptrons and one output neuron used to generate any monomial can also be used to generate any full term. To do so, each input variable $x_i$ is assigned to one perceptron, and the weights of each perceptron are all set to 0 except the one of the assigned input variable, which is set to 1. If the variable appears in the term non-negated, the bias in of the corresponding perceptron is set to 0, and to 1 otherwise. Lastly, the last neuron only computes the product of all outputs of the perceptrons, so its bias and all its weights are set to 0.

Figure 7(c) shows the symbol used in the following to indicate a Boolean full term.

A circuit to implement a Boolean function in Disjunctive Normal Form (DNF) will now be described.

Any Boolean function can be written as the disjunction (OR) of full terms of its inputs. This standard expression of a Boolean function is called full Disjunctive Normal Form (DNF) and its general expression can be written as:

$$f(x) = b_1 \gamma^1 \vee \dots \vee b_K \gamma^K, \qquad (10)$$

where the coefficients $b_k$, $k = 1, \dots, 2^M$ take value 1 if the corresponding term $\gamma^k$ appears in the full DNF of $f(x)$, and 0 otherwise.

To build a circuit that implements any full DNF using only the binary field neuron, it is necessary to build OR gates using this neuron exclusively. This can also be done with the circuit shown in Figure 7(a). Consider a function that computes the OR between some of its inputs. The general expression of this function is:

$$g(x) = \alpha_1 x_1 \vee \dots \vee \alpha_M x_M, \qquad (11)$$

where $\alpha_i$ = 1 if variable $x_i$ appears in the OR operation and 0 otherwise. The operation computed by $g(x)$ is referred to below as a weighted OR. Applying De Morgan's law the function computed by $g(x)$ can be rewritten as:

$$\begin{aligned}
g(x) &= \alpha_1 x_1 \vee \dots \vee \alpha_M x_M, \\
&= \overline{\overline{\alpha_1 x_1 \vee \dots \vee \alpha_M x_M}} \\
&= \overline{\overline{\alpha_1 x_1} \wedge \dots \wedge \overline{\alpha_M x_M}} \\
&= 1 \oplus (1 \oplus \alpha_1 x_1) \dots (1 \oplus \alpha_M x_M), \qquad (12)
\end{aligned}$$

The expression in the last line of Equation (12) can be implemented by the network shown in Figure 7(a), choosing the weights of each neuron conveniently. The symbol shown in Figure 9(a) is used to indicate a network that computes the weighted OR of its M inputs for some choice of parameters $\alpha_1, \dots, \alpha_M$, and the symbol in Figure 9(b) to indicate a "standard" OR operation of $M$ input variables, or equivalently a weighted OR with $\alpha_i$ = 1, $i$ = 1, ... , $M$.

For practical reasons, it may be more efficient to implement the OR gates in hardware directly with actual OR gates, instead of combining many neurons that require themselves many elementary Boolean gates.

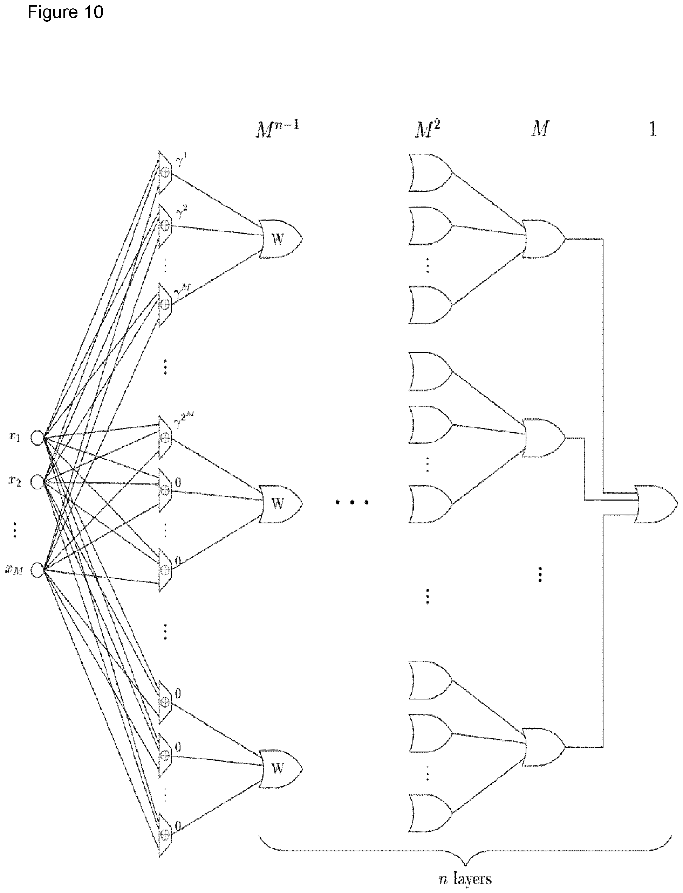

Figure 10 shows a network built exclusively with the binary field neuron that can compute any full DNF of $M$ input variables. Since any Boolean function can be written in full DNF, this network can implement any Boolean function of $M$ inputs.

Similarly to the network that computes any ANF, the first three layers of the network in Figure 10 are used to generate all $2^M$ possible terms of $M$ variables. Out of these, the terms that will compose the DNF are selected with the parameters of the weighted OR gates built with the three following layers. After these, the network is just a cascade of OR gates that computes the disjunction of all selected terms.

Unlike the ANF, where the number of monomials generated $M^n$ should satisfy $M^n > 2^M + M^{(n-1)}$ to propagate the zeros, in this case, the number of monomials generated should satisfy $M^n > 2^M$, since the tree structure previously generated with neurons has been replaced with OR (or weighted OR) gates. In turn, the depth of the tree has been multiplied by 3, since to have $n$ layers of OR gates, $3n$ layers of neurons are required.

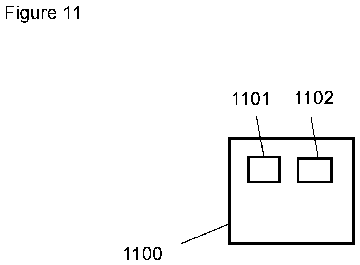

Figure 11 shows a schematic diagram of a data processing system 1100 configured to implement the networks described above and its associated components. The system may comprise a processor 1101 and a non-volatile memory 1102. The system may comprise more than one processor and more than one memory. The memory may store data that is executable by the processor. The processor may be configured to operate in accordance with a computer program stored in non-transitory form on a machine readable storage medium. The computer program may store instructions for causing the processor to perform its methods in the manner described herein.

In one particular implementation, the data processing system described above may be implemented as part of a communication terminal, such as a smartphone. The smartphone may comprise a sensor, such as a camera, from which sensed data is provided to form the network input. The terminal may be configured to perform error correction on data received over a communication link using the data processing system. The data processing system may be used for applications including image recognition, portrait mode photography, text prediction, user profiling, de-noising and camera enhancement.

The system may be implemented as a plurality of sub-systems, each of the sub-systems comprising a network as described in one of the embodiments above. In this arrangement, the output of the network of at least one of the sub-systems can be provided as an input to at least one of the other sub-systems' networks. The connections between the plurality of sub-systems can be configured in dependence on the desired Boolean function to be implemented.

The approach of the present disclosure trains a "binary field" neuron and/or neural network without continuous components. This is made possible due to the particular design of the neuron. The present disclosure models the weight vector of each neuron as an error correcting code and formulates the neuron training problem as a channel decoding problem. The binary-field artificial neurons have parameters which implement an error correcting code. The methods used for decoding this type of neuron and for decoding BNNs have also been described, along with logical circuits that can implement this neuron and BNNs that are based on this type of neuron, and their corresponding implementation in virtual environments.

The proposed solution has numerous advantages over the prior art.

The approach can be implemented on artificial intelligence chipsets in a simple, standalone and modular manner, as required for mass production.

This solution presents minor losses in accuracy for dramatic benefits in simplicity, space, thermal properties, memory requirements, and energy consumption and can be used for federated learning, user profiling, privacy, security and optimal control.

The approach takes one step closer to a precise form of Boolean functions to be used, inspired by properties from the channel coding theory.

In view of the foregoing description it will be evident to a person skilled in the art that various modifications may be made within the scope of the invention as defined in the appended claims.

**Claims**

1. A data processing system having a neural network architecture for receiving a binary network input and, in dependence on the binary network input, propagating signals via a plurality of binary processing nodes, in accordance with respective binary weights, to form a network output, the data processing system being configured to train each node of the plurality of binary processing nodes by implementing an error correcting function that expresses an error correction code to identify a set of binary weights which minimize, for a given input to the respective node, any error between an output of the respective node when formed in accordance with current binary weights of the respective node and a preferred output from the respective node, and to update the binary weights of the respective node to be the identified binary weights.

2. The data processing system as claimed in claim 1, wherein the respective node is configured to receive a node input dependent on the binary network input and to form a node output that is binary and functionally equal to a sum in the binary field of (i) a first weight, (ii) the sum in the binary field of products of (a) each of the bits of the node input, (b) a respective one of a set of second weights, and (iii) a value indicative of whether all the bits of the node input are non-zero.

3.  The data processing system as claimed in claim 2, wherein the one of the nodes is configured to form a node output that is functionally equal to a coset of a first-order Reed-Muller code, wherein the coset kernel takes as input the bits of the node input.

4.  The data processing system as claimed in claim 2, wherein the respective node is implemented as a set of logic circuits configured so that:

    (i) each bit of the node input is subject to a logical AND function with a respective weight to form a respective first intermediate value;
    (ii) all bits of the node input are together subject to a logical AND function to form a second intermediate value; and
    (iii) a further weight, the first intermediate value, and the second intermediate value are together subject to a logical XOR function to form the node output.

5.  The data processing system as claimed in claim 4, wherein the network comprises a plurality of blocks, each block comprising at least three logic circuits as set out in claim 3, the logic circuits being configured so that first and second ones of the logic circuits receive block inputs dependent on the network input and form first and second intermediate block values, and the third one of the logic circuits receives as input the intermediate block values and forms an output from the block.

6.  The data processing system as claimed in claim 5, wherein the first logic circuit is configured to apply weights as the weights of a binary perceptron and the second logic circuit has fixed weights.

7.  The data processing system as claimed in claim 6, wherein the fixed weights are zero.

8.  The data processing system as claimed in claim 6 or 7, wherein the third logic circuit receives as input (i) a single instance of the first intermediate block value, and (ii) multiple instances of the second intermediate block value.

9.  The data processing system as claimed in claim 8, wherein the third logic circuit is configured to apply fixed weights to all the inputs of the third logic circuit with the exception of one instance of the second intermediate block value.

10. The data processing system as claimed in claim 9, wherein the third logic circuit is configured to apply a weight equal to the sum in the binary field of the weights of the first logical circuit to the instance of the second intermediate block value.

11. A data processing system comprising a plurality of sub-systems, the sub-systems each comprising the data processing system as claimed in any of claims 1 to 10, wherein the data processing system is configured to provide the output of at least one of the sub-systems as an input to at least one of the other sub-systems.

12. The data processing system as claimed in claim 11, wherein the connections between the plurality of sub-systems are configured in dependence on the desired Boolean function to be implemented.

13. The data processing system as claimed in any preceding claim, the data processing system being configured to adapt the weights for the respective node in dependence on a set of expected node outputs expected for a set of node inputs by the steps of:

    forming a set of values representing, for each node input, whether the expected node output is (i) zero, (ii) one or (iii) indifferent; and
    identifying an $i^{th}$ row of a Hadamard matrix that best matches the set of values; and
    adapting the weights for the node in dependence on the identification.

14. The data processing system as claimed in any preceding claim, the data processing system being configured to form a set of values representing, for each node input, whether the respective node output obtained after the weights have been adapted matches the expected node output.

15. The data processing system as claimed in any of claims 1 to 14, the data processing system being configured to adapt the weights for the respective node in dependence on a set of expected node outputs expected for a set of node inputs by operating a fast Walsh-Hadamard function taking as input the set of expected node outputs.

16. A communication terminal comprising a sensor and a data processing system as claimed in any preceding claim, the communication terminal being configured to sense data by means of the sensor to form the network input.

17. The communication terminal as claimed in claim 16, wherein the sensor is a camera.

18. The communication terminal as claimed in claim 16 or 17, the terminal being configured to perform error correction on data received over a communication link using the data processing system.

19. A computer program for implementation in a system having a neural network architecture for receiving a binary network input and, in dependence on the binary network input, propagating signals via a plurality of binary processing nodes, in accordance with respective binary weights, to form a network output, which, when executed by a computer, causes the computer to perform a method comprising training each node of the plurality of binary processing nodes by implementing an error correcting function that expresses an error correction code to identify a set of binary weights which minimize, for a given input to the respective node, any error between an output of the respective node when formed in accordance with current binary weights of the respective node and a preferred output from the respective node and to update the weights of the respective node to be the identified weights.

**Patentansprüche**

1. Datenverarbeitungssystem, das eine Architektur eines neuronalen Netzes aufweist, zum Empfangen einer binären Netzeingabe und, in Abhängigkeit von der binären Netzeingabe, zum Ausbreiten von Signalen über eine Vielzahl von binären Verarbeitungsknoten gemäß jeweiligen binären Gewichtungen, um eine Netzausgabe auszubilden, wobei das Datenverarbeitungssystem konfiguriert ist, um jeden Knoten der Vielzahl von binären Verarbeitungsknoten durch Implementieren einer Fehlerkorrekturfunktion zu trainieren, die einen Fehlerkorrekturcode ausdrückt, um einen Satz von binären Gewichtungen zu identifizieren, die, für eine gegebene Eingabe in den jeweiligen Knoten, einen beliebigen Fehler zwischen einer Ausgabe des jeweiligen Knotens, wenn er gemäß aktuellen binären Gewichtungen des jeweiligen Knotens ausgebildet wird, und einer bevorzugten Ausgabe von dem jeweiligen Knoten minimieren, und um die binären Gewichtungen des jeweiligen Knotens zu aktualisieren, um die identifizierten binären Gewichtungen zu sein.

2. Datenverarbeitungssystem nach Anspruch 1, wobei der jeweilige Knoten konfiguriert ist, um eine Knoteneingabe, die von der binären Netzeingabe abhängig ist, zu empfangen und um eine Knotenausgabe auszubilden, die binär und funktionell gleich einer Summe in dem binären Feld von (i) einer ersten Gewichtung, (ii) der Summe in dem binären Feld von Produkten aus (a) jedem der Bits der Knoteneingabe, (b) einem jeweiligen von einem Satz von zweiten Gewichtungen und (iii) einem Wert, der angibt, ob alle Bits der Knoteneingabe ungleich null sind, ist.

3. Datenverarbeitungssystem nach Anspruch 2, wobei der eine der Knoten konfiguriert ist, um eine Knotenausgabe auszubilden, die funktionell gleich einer Restklasse eines Reed-Muller-Codes erster Ordnung ist, wobei der Restklasse-Kernel die Bits der Knoteneingabe als Eingabe verwendet.

4. Datenverarbeitungssystem nach Anspruch 2, wobei der jeweilige Knoten als ein Satz logischer Schaltungen implementiert ist, die so konfiguriert sind, dass:

   (i) jedes Bit der Knoteneingabe einer logischen UND-Funktion mit einer jeweiligen Gewichtung unterzogen wird, um einen jeweiligen ersten Zwischenwert auszubilden,
   (ii) alle Bits der Knoteneingabe zusammen einer logischen UND-Funktion unterzogen werden, um einen zweiten Zwischenwert auszubilden, und
   (iii) eine weitere Gewichtung, der erste Zwischenwert und der zweite Zwischenwert zusammen einer logischen XOR-Funktion unterzogen werden, um die Knotenausgabe auszubilden.

5. Datenverarbeitungssystem nach Anspruch 4, wobei das Netz eine Vielzahl von Blöcken umfasst, wobei jeder Block mindestens drei logische Schaltungen gemäß Anspruch 3 umfasst, wobei die logischen Schaltungen so konfiguriert sind, dass die erste und die zweite der logischen Schaltungen Blockeingaben empfangen, die von der Netzeingabe abhängen und erste und zweite Zwischenblockwerte ausbilden, und der dritte der logischen Schaltungen die Zwischenblockwerte als Eingabe empfängt und eine Ausgabe von dem Block ausbildet.

**6.** Datenverarbeitungssystem nach Anspruch 5, wobei die erste logische Schaltung konfiguriert ist, um Gewichtungen als die Gewichtungen eines binären Perzeptrons anzuwenden, und die zweite logische Schaltung feste Gewichtungen aufweist.

**7.** Datenverarbeitungssystem nach Anspruch 6, wobei die festen Gewichtungen null sind.

**8.** Datenverarbeitungssystem nach Anspruch 6 oder 7, wobei die dritte logische Schaltung (i) eine einzelne Instanz des ersten Zwischenblockwerts und (ii) mehrere Instanzen des zweiten Zwischenblockwerts als Eingabe empfängt.

**9.** Datenverarbeitungssystem nach Anspruch 8, wobei die dritte logische Schaltung konfiguriert ist, um feste Gewichtungen auf alle Eingaben der dritten logischen Schaltung mit Ausnahme einer Instanz des zweiten Zwischenblockwerts anzuwenden.

**10.** Datenverarbeitungssystem nach Anspruch 9, wobei die dritte logische Schaltung konfiguriert ist, um eine Gewichtung, die gleich der Summe der Gewichtungen der ersten logischen Schaltung in dem binären Feld ist, auf die Instanz des zweiten Zwischenblockwerts anzuwenden.

**11.** Datenverarbeitungssystem, das eine Vielzahl von Teilsystemen umfasst, wobei die Teilsysteme jeweils das Datenverarbeitungssystem nach einem der Ansprüche 1 bis 10 umfassen, wobei das Datenverarbeitungssystem konfiguriert ist, um die Ausgabe mindestens eines der Teilsysteme als eine Eingabe in mindestens eines der anderen Teilsysteme bereitzustellen.

**12.** Datenverarbeitungssystem nach Anspruch 11, wobei die Verbindungen zwischen der Vielzahl von Teilsystemen in Abhängigkeit von der gewünschten zu implementierenden booleschen Funktion konfiguriert sind.

**13.** Datenverarbeitungssystem nach einem der vorstehenden Ansprüche, wobei das Datenverarbeitungssystem konfiguriert ist, um die Gewichtungen für den jeweiligen Knoten in Abhängigkeit von einem Satz erwarteter Knotenausgaben, die für einen Satz von Knoteneingaben erwartet werden, durch die Schritte anzupassen:

Ausbilden eines Satzes von Werten, die für jede Knoteneingabe darstellen, ob die erwartete Knotenausgabe (i) null, (ii) eins oder (iii) indifferent ist, und
Identifizieren einer $i$-ten Zeile einer Hadamard-Matrix, die am besten mit dem Satz von Werten übereinstimmt; und Anpassen der Gewichtungen für den Knoten in Abhängigkeit von der Identifikation.

**14.** Datenverarbeitungssystem nach einem der vorstehenden Ansprüche, wobei das Datenverarbeitungssystem konfiguriert ist, um einen Satz von Werten auszubilden, die für jede Knoteneingabe darstellen, ob die jeweilige Knotenausgabe, die erhalten wird, nachdem die Gewichtungen angepasst wurden, mit der erwarteten Knotenausgabe übereinstimmt.

**15.** Datenverarbeitungssystem nach einem der Ansprüche 1 bis 14, wobei das Datenverarbeitungssystem konfiguriert ist, um die Gewichtungen für den jeweiligen Knoten in Abhängigkeit von einem Satz erwarteter Knotenausgaben, die für einen Satz von Knoteneingaben erwartet werden, durch Betreiben einer schnellen Walsh-Hadamard-Funktion, die den Satz erwarteter Knotenausgaben als Eingabe verwendet, anzupassen.

**16.** Kommunikationsendgerät, das einen Sensor und ein Datenverarbeitungssystem nach einem der vorstehenden Ansprüche umfasst, wobei das Kommunikationsendgerät konfiguriert ist, um Daten mittels des Sensors zu erfassen, um die Netzeingabe auszubilden.

**17.** Kommunikationsendgerät nach Anspruch 16, wobei der Sensor eine Kamera ist.

**18.** Kommunikationsendgerät nach Anspruch 16 oder 17, wobei das Endgerät konfiguriert ist, um eine Fehlerkorrektur an Daten, die über eine Kommunikationsverbindung empfangen werden, unter Nutzung des Datenverarbeitungssystems durchzuführen.

**19.** Computerprogramm für die Implementierung in einem System, das eine Architektur des neuronalen Netzes aufweist, zum Empfangen einer binären Netzeingabe, und, in Abhängigkeit von der binären Netzeingabe, zum Ausbreiten von Signalen über eine Vielzahl von binären Verarbeitungsknoten gemäß jeweiligen binären Gewichtungen, um eine Netzausgabe auszubilden, die, wenn sie durch einen Computer ausgeführt wird, den Computer veranlasst, ein Verfahren durchzuführen, das das Trainieren jedes Knotens der Vielzahl von binären Verarbeitungsknoten durch Implementieren einer Fehlerkorrekturfunktion umfasst, die einen Fehlerkorrekturcode ausdrückt, um einen Satz von binären Gewichtungen zu identifizieren, die, für eine gegebene Eingabe in den jeweiligen Knoten, einen beliebigen Fehler zwischen einer Ausgabe des jeweiligen Knotens, wenn er gemäß aktuellen binären Gewichtungen des jeweiligen Knotens ausgebildet wird, und einer bevorzugten Ausgabe von dem jeweiligen Knoten zu minimieren, und um die Gewichtungen des jeweiligen Knotens zu aktualisieren, um die identifizierten Gewichtungen zu sein.

**Revendications**

1. Système de traitement de données ayant une architecture de réseau neuronal permettant de recevoir une entrée de réseau binaire et, en fonction de l'entrée de réseau binaire, propager des signaux par l'intermédiaire d'une pluralité de noeuds de traitement binaire, conformément à des poids binaires respectifs, pour former une sortie de réseau, le système de traitement de données étant configuré pour entraîner chaque noeud de la pluralité de noeuds de traitement binaire en mettant en oeuvre une fonction de correction d'erreur qui exprime un code de correction d'erreur pour identifier un ensemble de poids binaires qui minimisent, pour une entrée donnée du noeud respectif, toute erreur entre une sortie du noeud respectif lorsqu'elle est formée conformément aux poids binaires actuels du noeud respectif et à une sortie préférée du noeud respectif, et pour mettre à jour les poids binaires du noeud respectif comme étant les poids binaires identifiés.

2. Système de traitement de données selon la revendication 1, dans lequel le noeud respectif est configuré pour recevoir une entrée de noeud dépendant de l'entrée de réseau binaire et pour former une sortie de noeud qui est binaire et fonctionnellement égale à une somme dans le champ binaire de (i) un premier poids, (ii) la somme dans le champ binaire des produits de (a) chacun des bits de l'entrée de noeud, (b) un poids respectif d'un ensemble de seconds poids, et (iii) une valeur indiquant si tous les bits de l'entrée de noeud sont non nuls.

3. Système de traitement de données selon la revendication 2, dans lequel l'un des noeuds est configuré pour former une sortie de noeud qui est fonctionnellement égale à un coset d'un code Reed-Muller du premier ordre, le noyau de coset prenant comme entrée les bits de l'entrée du noeud.

4. Système de traitement de données selon la revendication 2, dans lequel le noeud respectif est mis en oeuvre sous la forme d'un ensemble de circuits logiques configuré de sorte que :

   (i) chaque bit de l'entrée de noeud est soumis à une fonction ET logique avec un poids respectif pour former une première valeur intermédiaire respective ;
   (ii) tous les bits de l'entrée de noeud sont soumis ensemble à une fonction ET logique pour former une seconde valeur intermédiaire ; et
   (iii) un poids supplémentaire, la première valeur intermédiaire et la seconde valeur intermédiaire sont soumises ensemble à une fonction XOR logique pour former la sortie du noeud.

5. Système de traitement de données selon la revendication 4, dans lequel le réseau comprend une pluralité de blocs, chaque bloc comprenant au moins trois circuits logiques selon la revendication 3, les circuits logiques étant configurés de sorte que les premier et deuxième des circuits logiques reçoivent des entrées de bloc dépendant de l'entrée de réseau et formant des première et seconde valeurs de bloc intermédiaires, et le troisième des circuits logiques reçoit en entrée les valeurs de bloc intermédiaires et forme une sortie du bloc.

6. Système de traitement de données selon la revendication 5, dans lequel le premier circuit logique est configuré pour appliquer des poids comme poids d'un perceptron binaire et le deuxième circuit logique a des poids fixes.

7. Système de traitement de données selon la revendication 6, dans lequel les poids fixes sont nuls.

8. Système de traitement de données selon la revendication 6 ou 7, dans lequel le troisième circuit logique reçoit comme entrée (i) une seule instance de la première valeur de bloc intermédiaire, et (ii) plusieurs instances de la seconde valeur de bloc intermédiaire.

9. Système de traitement de données selon la revendication 8, dans lequel le troisième circuit logique est configuré pour appliquer des poids fixes à toutes les entrées du troisième circuit logique à l'exception d'une instance de la seconde valeur de bloc intermédiaire.

**10.** Système de traitement de données selon la revendication 9, dans lequel le troisième circuit logique est configuré pour appliquer un poids égal à la somme dans le champ binaire des poids du premier circuit logique à l'instance de la seconde valeur de bloc intermédiaire.

**11.** Système de traitement de données comprenant une pluralité de sous-systèmes, les sous-systèmes comprenant chacun le système de traitement de données selon l'une quelconque des revendications 1 à 10, dans lequel le système de traitement de données est configuré pour fournir la sortie d'au moins l'un des sous-systèmes comme entrée dans au moins l'un des autres sous-systèmes.

**12.** Système de traitement de données selon la revendication 11, dans lequel les connexions entre la pluralité de sous-systèmes sont configurées en fonction de la fonction booléenne souhaitée à mettre en oeuvre.

**13.** Système de traitement de données selon l'une quelconque revendication précédente, le système de traitement de données étant configuré pour adapter les poids pour le noeud respectif en fonction d'un ensemble de sorties de noeud attendues pour un ensemble d'entrées de noeud par les étapes consistant à :

former un ensemble de valeurs représentant, pour chaque entrée de noeud, si la sortie de noeud attendue est (i) nulle, (ii) un ou (iii) indifférente ; et
identifier une $i^{ème}$ rangée d'une matrice de Hadamard qui correspond le mieux à l'ensemble de valeurs ; et
adapter les poids pour le noeud en fonction de l'identification.

**14.** Système de traitement de données selon l'une quelconque revendication précédente, le système de traitement de données étant configuré pour former un ensemble de valeurs représentant, pour chaque entrée de noeud, si la sortie de noeud respective obtenue après l'adaptation des poids correspond à la sortie de noeud attendue.

**15.** Système de traitement de données selon l'une quelconque des revendications 1 à 14, le système de traitement de données étant configuré pour adapter les poids pour le noeud respectif en fonction d'un ensemble de sorties de noeud attendues pour un ensemble d'entrées de noeud en faisant fonctionner une fonction de Walsh-Hadamard rapide prenant comme entrée l'ensemble de sorties de noeud attendues.

**16.** Terminal de communication comprenant un capteur et un système de traitement de données selon l'une quelconque revendication précédente, le terminal de communication étant configuré pour détecter des données au moyen du capteur pour former l'entrée de réseau.

**17.** Terminal de communication selon la revendication 16, dans lequel le capteur est une caméra.

**18.** Terminal de communication selon la revendication 16 ou 17, le terminal étant configuré pour effectuer une correction d'erreur sur des données reçues sur une liaison de communication à l'aide du système de traitement de données.

**19.** Programme informatique à mettre en oeuvre dans un système ayant une architecture de réseau neuronal pour recevoir une entrée de réseau binaire et, en fonction de l'entrée de réseau binaire, propager des signaux par l'intermédiaire d'une pluralité de noeuds de traitement binaires, conformément à des poids binaires respectifs, pour former un réseau de sortie, qui, lorsqu'elle est exécutée par un ordinateur, amène l'ordinateur à effectuer un procédé comprenant l'entraînement de chaque noeud de la pluralité de noeuds de traitement binaire en mettant en oeuvre une fonction de correction d'erreur qui exprime un code de correction d'erreur pour identifier un ensemble de poids binaires qui minimisent, pour une entrée donnée du noeud respectif, une erreur quelconque entre une sortie du noeud respectif lorsqu'elle est formée conformément aux poids binaires actuels du noeud respectif et une sortie préférée du noeud respectif et pour mettre à jour les poids du noeud respectif comme étant les poids identifiés.

Figure 1

Figure 2

Figure 3

Figure 4

Figure 5

Figure 6 (a)

601

602

603

Figure 6 (b)

Figure 7 (a)

603

Figure 7 (b)

(c)

Figure 8

Figure 9 (a)                    Figure 9 (b)

Figure 10

Figure 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 1992012497 A1
- US 10089577 B2
- WO 199204687 A1
- EP 0548127 A0

**Non-patent literature cited in the description**

- **I. HUBARA ; M. COURBARIAUX ; D. SOUDRY ; R. EI-YANIV ; Y. BENGIO.** Quantized Neural Networks: Training Neural Networks with Low Precision Weights and Activations. *Journal of Machine Learning Research,* 2017, vol. 18 (187), 1-30
- **M. RASTEGARI ; V. ORDONEZ ; J. REDMON ; A. FARHADI.** XNOR-Net: ImageNet Classification Using Binary Convolutional Neural Networks. *European Conference on Computer Vision,* 2016, 525-542
- **C. LENG ; Z. DOU ; H. LI ; S. ZHU ; R. JIN.** Extremely Low Bit Neural Network: Squeeze the Last Bit Out with ADMM. *The Thirty-Second AAAI Conference on Artificial Intelligence (AAAI-18),* 3466-3473
- **D. SOUDRY ; I HUBARA ; R. MEIR.** Expectation Backpropagation: parameter-free training of multilayer neural networks with continuous or discrete weights. *27th International Conference on Neural Information Processing Systems (NIPS),* 2014
- **C. BALDASSI ; A. BRAUNSTEIN.** A Max-Sum algorithm for training discrete neural networks. *Journal of Statistical Mechanics: Theory and Experiments,* August 2015
- **C. BALDASSI.** Generalization Learning in a Perceptron with Binary Synapses. *Journal of Statistical Physics,* September 2009, vol. 136 (5), 902-916
- **C. BALDASSI ; A. INGROSSO ; C. LUCIBELLO ; L. SAGLIETTI ; R. ZECCHINA.** Subdominant Dense Clusters Allow for Simple Learning and High Computational Performance in Neural Networks with Discrete Synapses. *Physical Review Letters,* September 2015, vol. 115 (12
- **G. MORSE ; K. O. STANLEY.** Simple Evolutionary Optimization Can Rival Stochastic Gradient Descent in Neural Networks. *The Genetic and Evolutionary Computation Conference (GECCO),* July 2016
- **R. ITO ; T. SAITO.** Dynamic binary neural networks and evolutionary learning. *The International Joint Conference on Neural Networks (IJCNN),* July 2010
- **O'DONNELL R.** Analysis of boolean functions. Cambridge University Press, 05 June 2014